# EUROPÄISCHE PATENTSCHRIFT

(11) **EP 2 827 497 B1**
(45) Veröffentlichungstag und Bekanntmachung des Hinweises auf die Patenterteilung: **03.05.2017**
(21) Anmeldenummer: 14176575.0
(22) Anmeldetag: 10.07.2014
(51) Int. Cl.: H03K 17/96

(54) **Bedieneinrichtung für ein Elektrogerät und Elektrogerät**
Operating device for an electrical device and electrical device
Dispositif de commande pour un appareil électrique et appareil électrique

(30) Priorität: 18.07.2013 DE 102013214163
(43) Veröffentlichungstag der Anmeldung: 21.01.2015
(73) Patentinhaber: E.G.O. Elektro-Gerätebau GmbH, 75038 Oberderdingen (DE)
(72) Erfinder: Schmid, Dennis, 76703 Kraichtal (DE)
(74) Vertreter: Patentanwälte Ruff, Wilhelm, Beier, Dauster & Partner mbB

(56) Entgegenhaltungen:
- WO-A1-2012/126754
- WO-A1-2013/041520
- DE-A1-102011 077 899
- US-A- 5 917 165
- US-A1- 2012 161 795

## Beschreibung

Die Erfindung betrifft eine Bedieneinrichtung für ein Elektrogerät, wobei die Bedieneinrichtung mehrere Anzeigeelemente, mehrere kapazitive Sensorelemente als Bedienelemente und eine lichtdurchlässige Bedienfläche aufweist. Ebenso betrifft die Erfindung ein Elektrogerät mit einer solchen Bedieneinrichtung.

Eine entsprechende Bedieneinrichtung ist aus der DE 102011006021 A1 bekannt. Dort werden mehrere zueinander passende Einzel-Aufnahmegehäuse zusammengesetzt als gemeinsames Aufnahmegehäuse. In Durchgangsöffnungen sind Leuchtmittel als Anzeigeelemente vorgesehen. Auf der Oberseite des gemeinsamen Aufnahmegehäuses sind mehrere kapazitive Sensorelemente angeordnet, die insgesamt eine Fläche überspannen, wobei sie die Durchgangsöffnungen freilassen, so dass die darin angeordneten Leuchtmittel nach oben leuchten können. Je nach gewünschtem gemeinsamem Aufnahmegehäuse werden entsprechende Einzel-Aufnahmegehäuse zusammengesetzt und dann mit passenden Sensorelementen an der Oberseite versehen. Dies stellt für die Montage einen erheblichen Aufwand dar.

Aus der WO 2013/041520 A1 ist es bekannt, für eine Bedieneinrichtung mehrere zusammenhängende kurze rohrartige Teile aus Kunststoff zumindest bereichsweise elektrisch leitfähig zu machen bzw. mit elektrisch leitfähigem Material zu versehen. Sie können dann auf eine Leiterplatte aufgesetzt werden und schirmen dabei LED als Lichtquellen nach außen ab. Durch das elektrisch leitfähige Material wird ein kapazitives Sensorelement gebildet, welches an der Unterseite einer Bedienfläche anliegt und so einen kapazitiven Berührungsschalter bildet.

Aus der DE 10 2011 077 899 A1 ist es bekannt, ein zusammenhängendes Lichtleiterteil auszubilden. Dieses ist mittels einzelner lichtundurchlässiger Abschnitte in Lichtleitkanäle gebildet durch lichtdurchlässige Abschnitte aufgeteilt. Unterhalb dieser lichtundurchlässigen Abschnitte sind flächige Sensorelektroden angeordnet, die somit die Beleuchtung nicht stören und die kapazitive Berührungsschalter bilden.

Der Erfindung liegt die Aufgabe zugrunde, eine eingangs genannte Bedieneinrichtung sowie ein damit versehenes Elektrogerät zu schaffen, mit denen Probleme des Standes der Technik vermieden werden können und es insbesondere möglich ist, bei vielseitiger Anwendung eine Montage der Bedieneinrichtung, insbesondere in ein Elektrogerät, einfach, praxistauglich und ausfallsicher zu gestalten.

Gelöst wird diese Aufgabe durch eine Bedieneinrichtung mit den Merkmalen des Anspruchs 1 sowie ein Elektrogerät mit den Merkmalen des Anspruchs 15. Vorteilhafte sowie bevorzugte Ausgestaltungen der Erfindung sind Gegenstand der weiteren Ansprüche und werden im Folgenden näher erläutert. Dabei werden manche der Merkmale nur für die Bedieneinrichtung oder nur für das Elektrogerät beschrieben. Sie sollen jedoch unabhängig davon sowohl für die Bedieneinrichtung als auch für das Elektrogerät selbstständig gelten können. Der Wortlaut der Ansprüche wird durch ausdrückliche Bezugnahme zum Inhalt der Beschreibung gemacht.

Es ist vorgesehen, dass die Bedieneinrichtung mehrere Anzeigeelemente, mehrere kapazitive Sensorelemente als Bedienelemente und eine lichtdurchlässige Bedienfläche oder Blende als Bedienfläche aufweist. Die Bedienfläche kann in das Elektrogerät integriert sein bzw. kann eine Bedienfläche, Oberfläche oder Wandung des Elektrogeräts selbst bilden, beispielsweise bei einem Elektrokochfeld eine Kochfeldplatte. Unter der Bedienfläche sind die Anzeigeelemente und die Sensorelemente angeordnet, wobei eine Bedienung durch Auflegen eines Fingers auf die Bedienfläche und/oder Darüberziehen eines auf die Bedienfläche aufgelegten Fingers erfolgen kann. Dabei sind vorteilhaft mindestens zwei kapazitive Sensorelemente vorgesehen, die voneinander elektrisch getrennt und/oder beabstandet sind. Diese Sensorelemente sind dabei an einer Oberseite des Aufnahmegehäuses angeordnet, die zur Bedienfläche hin weist, vorteilhaft liegen sie an einer Unterseite der Bedienfläche an. Des Weiteren verlaufen die Sensorelemente mindestens an dieser Oberseite zwischen den Lichtleitkanälen, so dass sie insbesondere nach Art eines Gitters oder Netzes ausgebildet sein können. Insgesamt spannen die Sensorelemente damit jeweils eine Fläche auf, an bzw. bei der wie vorbeschrieben an im Wesentlichen jedem Punkt eine Bedienung erfolgen bzw. erkannt werden kann. Das Aufnahmegehäuse weist Lichtleitkanäle auf, in denen Leuchtmittel als vorgenannte Anzeigeelemente angeordnet sein können. Die Lichtleitkanäle sind vorteilhaft gegeneinander abgeschirmt, so dass sich einzelne bzw. abgetrennte Leuchtanzeigen ergeben.

Erfindungsgemäß bestehen die Sensorelemente aus elektrisch leitfähigem Kunststoff bzw. aus elektrisch leitfähigem Elastomer. Sie sind in mindestens zwei, vorzugsweise drei, voneinander getrennte Bereiche auf dem Aufnahmegehäuse aufgeteilt, die vorteilhaft flächig sind. Es werden also, wie vorgenannt, mindestens zwei oder drei Sensorelemente gebildet. Innerhalb dieser Bereiche hängt jedes Sensorelement zusammen und wird durch durchgehenden Kunststoff bzw. einen durchgehenden Kunststoffstrang gebildet. Vorteilhaft verläuft der Kunststoff bzw. das Sensormaterial dabei als eine Art dünner Streifen oder dünne Rippe, beispielsweise mit einer Breite von maximal 5 mm oder sogar nur 2 oder 3 mm.

Die an der Unterseite der Bedienfläche anliegenden Sensorelemente bilden nach bekannter Art und Weise kapazitive Sensorelemente zur Bedienung bzw. die dadurch gebildeten Flächen ergeben dies. Durch die Elastizität des Kunststoffs bzw. des Sensormaterials kann eine über die Fläche des Aufnahmegehäuses gegebene Verteilung erreicht werden bzw. ein überall gegebenes gutes Anliegen. Somit können Lagetoleranzen oder -ungenauigkeiten ausgeglichen werden. Derartige Anpassungsmöglichkeiten sind mit den kapazitiven Sensorelementen gemäß dem vorbeschriebenen Stand der Technik aus dünnem Metallblech nicht möglich.

In vorteilhafter Ausgestaltung der Erfindung kann von jedem zusammenhängenden Sensorelement bzw. seinem zusammenhängenden elektrisch leitfähigen Kunststoff oder Sensormaterial eine elektrische Kontaktierung an einen unteren Bereich bzw. an eine Unterseite des Aufnahmegehäuses geführt sein, beispielsweise nach Art eines Leiters. Dies bildet einen elektrischen Anschluss an das Sensorelement. Vorteilhaft kann dies durch einen nach unten verlaufenden Verbindungsabschnitt erfolgen, der auch aus dem elektrisch leitfähigen Kunststoff besteht. Insbesondere ist ein solcher Verbindungsabschnitt einteilig und einstückig mit dem sonstigen Kunststoff dieses Sensorelements verbunden. Der Verbindungsabschnitt kann vorteilhaft am unteren Ende bzw. an der Unterseite des Aufnahmegehäuses einen Kontaktierungsabschnitt oder -vorsprung aufweisen. Damit kann er an ein Kontaktfeld auf einem Bauteilträger der Bedieneinrichtung, auf dem das Aufnahmegehäuse aufgesetzt ist, angedrückt sein für eine elektrische Kontaktierung. Diese kann durch einen elektrisch leitfähigen Leitkleber oder Leitpaste verbessert werden. So ist ein elektrischer Anschluss möglich einfach durch Andrücken des Kontaktierungsabschnitts an das Kontaktfeld bei Montage des Aufnahmegehäuses an dem Bauteilträger. Zusätzliche Arbeitsschritte sind dann nicht nötig.

In nochmals weiterer Ausgestaltung der Erfindung kann das Aufnahmegehäuse mit den Lichtleitkanälen, insbesondere auch mit den Sensorelementen, eine einzige Baueinheit bilden. Es kann also einteilig bzw. einstückig hergestellt sein. Dies vereinfacht eine Handhabung und Montage. Alternativ kann das Aufnahmegehäuse aus mehreren separaten Einzel-Aufnahmegehäusen bestehen, die dann auf gewünschte Weise zusammengesetzt sind, unter Umständen entweder vor Montage auf einen Bauteilträger miteinander verbunden werden, beispielsweise verklebt werden, oder aber bei der Montage auf den Bauteilträger das gesamte Aufnahmegehäuse ergeben.

In weiterer Ausgestaltung der Erfindung ist in den Lichtleitkanälen transparentes oder transluzentes Lichtleitermaterial angeordnet. Insbesondere transluzentes Lichtleitermaterial kann eine Beleuchtung durch Leuchtmittel wie LED odgl. gleichmäßig verteilt erscheinen lassen, wie dies an sich von solchen Anzeigen bekannt ist. Des Weiteren kann an einer Oberseite eines Lichtleitkanals, unter Umständen durch eine separate Maskierung bzw. Beschichtung, eine spezielle Zeichen- oder Symboldarstellung erfolgen.

Vorteilhaft sind die Leichtleitkanäle bzw. das darin befindliche Lichtleitermaterial zusammen mit dem Aufnahmegehäuse einteilig bzw. einstückig hergestellt. Dies kann in einem Mehrkomponenten-Kunststoffspritzgussverfahren erfolgen mit den jeweiligen Materialien. Vorteilhaft ist das Material für das Aufnahmegehäuse selbst lichtundurchlässig, so dass sich automatisch die voneinander getrennten Lichtleitkanäle ergeben.

In weiterer Ausgestaltung der Erfindung können die Sensorelemente zusammen mit dem Aufnahmegehäuse einteilig und einstückig hergestellt sein, wofür sich auch ein Mehrkomponenten-Kunststoffspritzgussverfahren anbietet. Somit können die Sensorelemente aus entsprechendem Sensormaterial an das Aufnahmegehäuse angespritzt werden. Als Sensormaterial bietet sich solches an, wie es beispielsweise aus der DE 102012010321 A1 bekannt ist, also vorteilhaft Elastomer bzw. TPE mit leitfähigen Zusätzen wie Ruß, Graphit oder Metallpartikeln.

Besonders vorteilhaft wird das Aufnahmegehäuse mit den Lichtleitkanälen bzw. dem Lichtleitermaterial dafür und den Sensorelementen bzw. dem Sensormaterial dafür einteilig und einstückig in einem Mehrkomponenten-Kunststoffspritzgussverfahren hergestellt. Es kann also ein sogenanntes 3K-Kunststoffspritzgussverfahren sein. Damit kann ein Aufnahmegehäuse hergestellt werden, welches dann nur noch auf einem vorgenannten Bauteilträger montiert werden muss, auf dem sich Kontaktfelder und LED als Leuchtmittel befinden.

Das Aufnahmegehäuse kann so ausgebildet sein, dass die Lichtleitkanäle in einer Längsrichtung des Aufnahmegehäuses gesehen in drei Reihen nebeneinander angeordnet sind bzw. verlaufen. Dabei können innerhalb einer Reihe alle Lichtleitkanäle gleich groß ausgebildet sein und insbesondere auch gleich ausgerichtet sein. Es ist möglich, die Lichtleitkanäle der linken Reihe und der rechten Reihe gleich groß auszugestalten. Sie können beispielsweise rechteckig und insbesondere nahezu quadratisch sein. Die Lichtleitkanäle der mittleren Reihe können vorteilhaft größer ausgebildet sein und breiter als hoch. Besonders vorteilhaft sind sie dabei gleich hoch wie die der seitlichen Reihen daneben, aber breiter, vorzugsweise etwa doppelt so breit.

Entlang der linken Reihe und entlang der rechten Reihe kann vorteilhaft in jedem Lichtleitkanal mindestens ein Leuchtmittel angeordnet sein. In den größeren mittleren Lichtleitkanälen können auch zwei Leuchtmittel vorgesehen sein oder ein helleres. Die Lichtleitkanäle einer Reihe sind dabei im Wesentlichen nur unterbrochen durch eine dünne Wand des Aufnahmegehäuses sowie ein darüber verlaufendes Sensorelement. Hier kann eine Wanddicke des Aufnahmegehäuses zwischen zwei Lichtleitkanälen wenige mm betragen, beispielsweise 0,5 mm bis 5 mm. Die linke und die rechte Reihe der Lichtleitkanäle können also symmetrisch zu einer Mittellängsachse des Aufnahmegehäuses ausgebildet sein.

Vorteilhaft sind in der mittleren Reihe von Lichtleitkanälen weniger Lichtleitkanäle vorgesehen. Besonders vorteilhaft kann nur entsprechend jedem zweiten Lichtleitkanal der linken Reihe bzw. der rechten Reihe ein mittlerer Lichtleitkanal vorgesehen sein. Dabei sollte sich an beiden Enden der mittleren Reihe jeweils ein Lichtleitkanal befinden. Alternativ können aber auch in der mittleren Reihe so viele Lichtleitkanäle vorgesehen sein wie in den benachbarten. So können jeweils nebeneinander liegende Lichtleitkanäle zumindest der äußeren Reihen, insbesondere auch der mittleren Reihe, gleich hoch sein und auf gleicher Höhe entlang der Mittellängsachse angeordnet sein.

Bei der Erfindung sind die Sensorelemente in einer Längsrichtung des Aufnahmegehäuses gesehen in verschiedene zusammenhängende Bereiche aufgeteilt. Pro zusammenhängenden Bereich verlaufen sie mindestens zweimal quer über die Oberseite des Aufnahmegehäuses. So spannen sie eine gewisse Fläche auf, innerhalb derer das Auflegen oder Darüberziehen eines Fingers erkannt werden kann, wie dies an sich von kapazitiven Sensorelementen oder aus dem vorgenannten Stand der Technik, insbesondere der DE 102012010321 A1, bekannt ist. Somit brauchen die Sensorelemente nicht diese gesamte Fläche durchgängig bzw. geschlossen zu überdecken. Damit kann ein beleuchtetes Bedienelement bzw. ein beleuchtetes kapazitives Bedienelement geschaffen werden, welches zum Einen reine Anzeigefunktionen aufweisen kann und zum Anderen auch eine Bedienhilfe gibt, indem das Auflegen eines Fingers direkt auf einen beleuchteten Bereich bzw. ein beleuchtetes Symbol, gebildet durch die Leuchtmittel eines Lichtleitkanals, möglich ist und erkannt wird. Insgesamt können somit die Sensorelemente in der Draufsicht netzartig oder gitterartig ausgebildet sein. Sie brauchen deswegen auch keine größere Fläche geschlossen zu überdecken bzw. besonders breit zu sein, eine vorgenannte Breite von wenigen Millimetern wird als ausreichend angesehen.

Das mit dieser Bedieneinrichtung versehene Elektrogerät ist vorteilhaft ein Elektro-Haushaltsgerät wie beispielsweise eine Wasch- oder Spülmaschine oder ein Backofen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine schräge Draufsicht auf ein Aufnahmegehäuse einer erfindungsgemäßen Bedieneinrichtung,
- Fig. 2: eine Seitenansicht einer erfindungsgemäßen Bedieneinrichtung mit dem Aufnahmegehäuse aus Fig. 1,
- Fig. 3: eine starke Vergrößerung des rechten Ende des Aufnahmegehäuses der Fig. 1 in der Seitenansicht,
- Fig. 4: ein Ablauf eines Bedien- bzw. Anzeigeverfahrens mit unterschiedlicher Aktivierung von LED im Aufnahmegehäuse und
- Fig. 5: eine Darstellung ähnlich der Fig. 4 mit einer Bedieneinrichtung mit einem abgewandelten, einfacheren Aufnahmegehäuse.

### Detaillierte Beschreibung der Ausführungsbeispiele

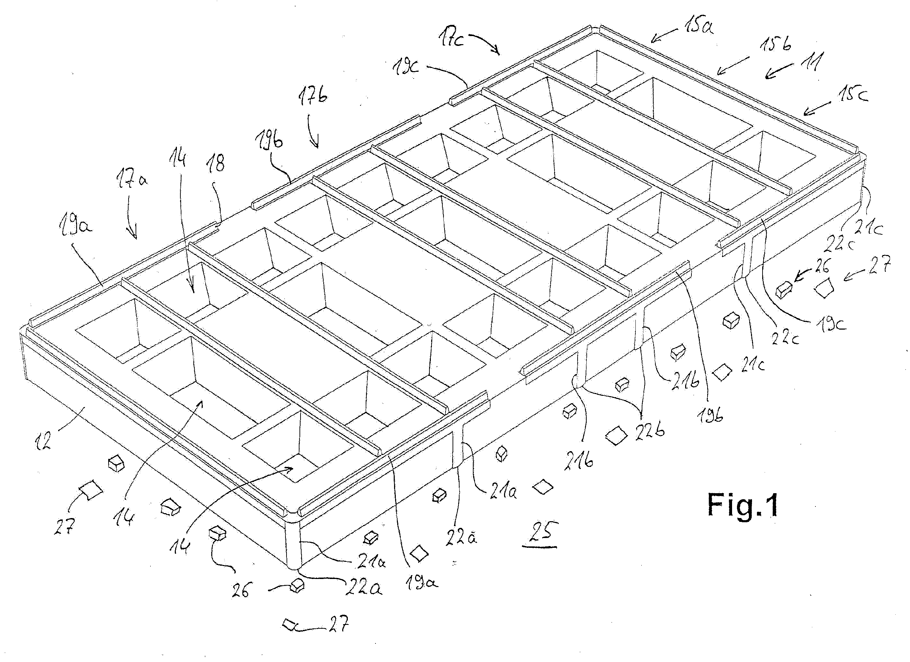

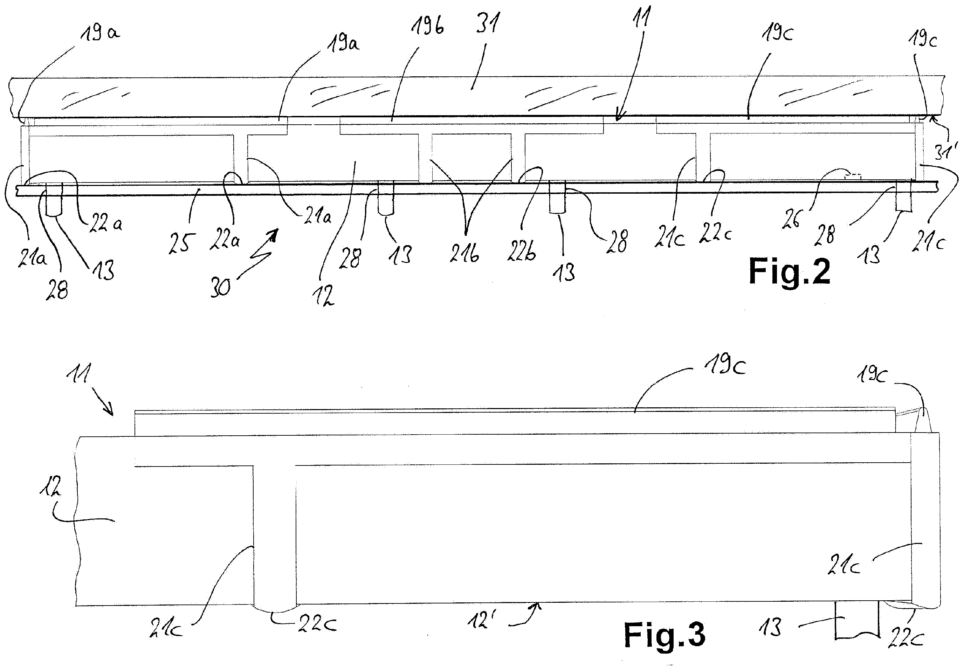

In der Fig. 1 ist eine Aufnahmegehäuse 11 in schräger Ansicht von oben dargestellt. Das Aufnahmegehäuse 11 weist einen einteiligen und durchgehenden, einstückigen Gehäusekörper 12 auf aus lichtundurchlässigem Kunststoff. Er kann maximal 10 cm lang sein, vorzugsweise 5 mm bis 2 cm oder 3 cm. Dabei kann er vorzugsweise 5 mm bis 2 cm breit sein sowie 2 mm bis 5 mm hoch sein. Das Aufnahmegehäuse 11 weist an der Unterseite 12', wie aus der Vergrößerung der Fig. 3 hervorgeht, Halteglieder 13 nach Art von abstehenden Haltefüßen auf. Diese sind integral am Gehäusekörper 12 angeformt.

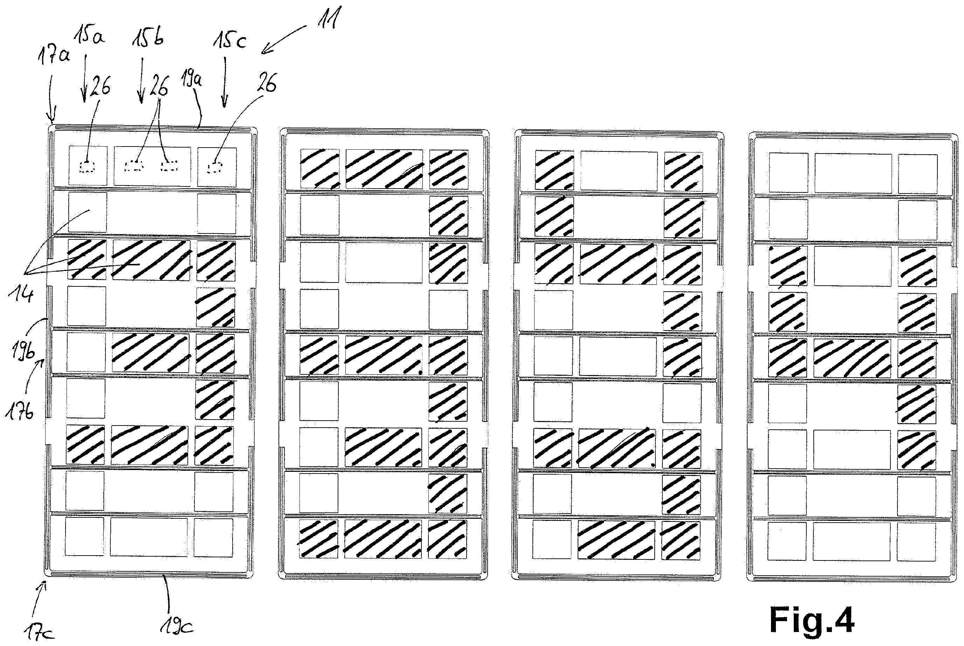

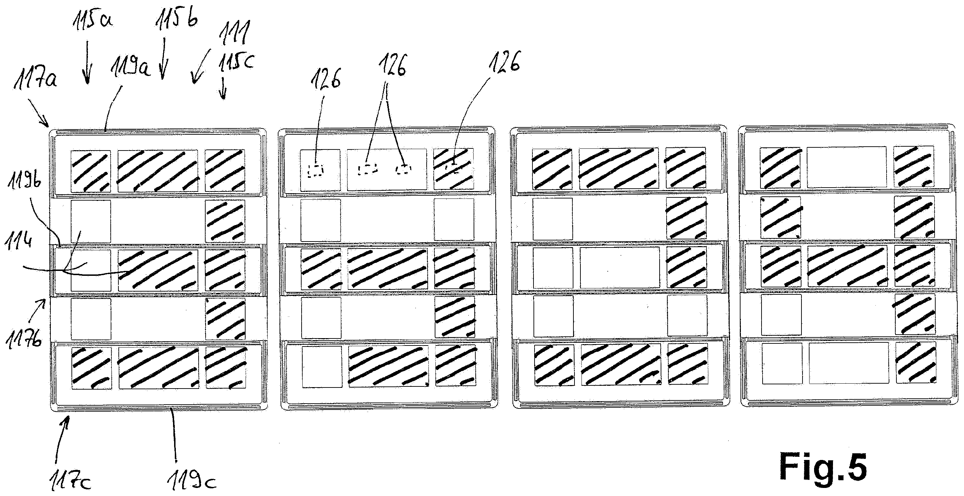

Des Weiteren weist das Aufnahmegehäuse 11 eine Vielzahl von Lichtleitkanälen 14 auf, welche in der Längsrichtung des Aufnahmegehäuses 11 gesehen entlang einer Reihe 15a, entlang einer Reihe 15b und einer Reihe 15 c angeordnet sind. In den Reihen 15a und 15c sind dabei neun jeweils kleinere, in der Draufsicht gesehen etwa quadratische Lichtleitkanäle 14 vorgesehen. Entlang der mittleren Reihe 15b sind fünf solcher Lichtleitkanäle 14 vorgesehen. Diese sind doppelt so breit wie diejenigen der Reihen 15a und 15c, wie beispielsweise in der Draufsicht aus der Fig. 4 zu ersehen ist. Des Weiteren ist im Vergleich zu den benachbarten Reihen 15a und 15c nur an jeder zweiten Stelle im sozusagen gebildeten Raster ein Lichtleitkanal 14 in der mittleren Reihe 15b vorgesehen. Dies muss aber nicht so sein, sondern ist hier im Wesentlichen aus Vereinfachungsgründen gemacht, wie schon in der eingangs genannten DE 102011006021 A1 erläutert worden ist und aus den Fig. 4 und 5 zu ersehen ist.

Die Lichtleitkanäle 14 können offen bzw. leer ausgebildet sein, wie es die Fig. 1 andeutet. Vorteilhaft enthalten sie aber ein zuvor beschriebenes Lichtleitermaterial, welches entweder transparent ist oder transluzent, also eine Diffusorwirkung für das von unten eingestrahlte Licht aufweist. Nach oben sollen die so gebildeten Anzeigeelemente als quadratische oder rechteckige Flächen erscheinen, selbstverständlich mit möglichst gleichmäßiger flächiger Ausleuchtung.

An dem Aufnahmegehäuse 11 sind drei Sensorelemente 17a, 17b und 17c vorgesehen. Diese bestehen aus elektrisch leitfähigem Sensormaterial 18, insbesondere aus elektrisch leitfähigem Kunststoff bzw. TPE. Die Sensorelemente 17a bis 17c weisen nach oben abstehende Rippen 19a bis 19c auf, wie es aus der Vergrößerung der Fig. 2 und 3 zu ersehen ist und beispielsweise auch aus der vorgenannten DE 102012010321 A1 zu entnehmen ist. Jedes netzartige bzw. gitterartige Sensorelement 17 besteht aus mehreren Strängen des dünnen Sensormaterials 18 bzw. den nach oben weisenden Rippen. Die Sensorelemente 17a bis 17c weisen an jeder der Längsseiten des Aufnahmegehäuses 11 zwei Verbindungsabschnitte 21a bis 21c nach unten auf bzw. diese sind am Aufnahmegehäuse 11 angeformt. Aus der Vergrößerung der Fig. 3 ist zu ersehen, dass diese Verbindungsabschnitte 21a bis 21c nach unten in Kontaktierungsvorsprünge 22a bis 22c münden bzw. übergehen, welche über eine sonstige Unterseite 12' des Gehäusekörpers 12 überstehen. Ähnlich wie eingangs erläutert, kann das Sensormaterial 18 für die Sensorelemente 17a bis 17c an den Gehäusekörper 12 angespritzt sein.

In der Fig. 2 ist unterhalb des Aufnahmegehäuses 11 eine parallele Leiterplatte 25 als Bauteilträger ausgebildet. Darauf sind auf übliche Art und Weise LED 26 und Kontaktfelder 27 angeordnet. Die LED 26 sind vorteilhaft SMD-LED und auf die Leiterplatte 25 samt elektrischer Kontaktierung aufgebracht. Sie sind so angeordnet, dass sie, wie in der Fig. 4 links oben zu ersehen ist, jeweils in etwa mittig innerhalb der Lichtleitkanäle 14 angeordnet sind und diese durchstrahlen. Für die Lichtleitkanäle 14 der mittleren Reihe 15b sind jeweils zwei LED 26 vorgesehen. Zur Befestigung werden die Halteglieder 13 des Gehäusekörpers 12 in Löcher 28 in der Leiterplatte 25 eingesteckt. Durch einen Passsitz kann eine ausreichende Befestigung erreicht werden.

Die Anordnung der Kontaktfelder 27 entspricht der Anordnung der Kontaktierungsvorsprünge 22a bis 22c. Es ist leicht zu erkennen aus der Zusammenschau der Fig. 1 bis 3, dass beim Aufsetzen des Aufnahmegehäuses 11 auf die Leiterplatte 25 ein elektrischer Kontakt zwischen den Kontaktierungsvorsprüngen 22 und den Kontaktfeldern 27 entsteht. Dieser kann evtl. noch durch Leitkleber zusätzlich verbessert werden.

Die Seitenansicht einer erfindungsgemäßen Bedieneinrichtung 30 gemäß der Fig. 2 zeigt, dass das Aufnahmegehäuse 11 unterhalb einer Abdeckung 31 als Bedienfläche angeordnet ist bzw. mit den Rippen 19a bis 19c an eine Unterseite 31' der Abdeckung 31 angedrückt ist. Die Kontaktflächen zwischen den Rippen 19a bis 19c und der Unterseite 31' bzw. die Oberseite der Rippen ergeben jeweils die kapazitiven Sensorelemente. Wird ein Finger auf die Oberseite der Abdeckung 31 bzw. Bedienfläche gelegt oder darüber bewegt, kann dies mit dem allgemein bekannten Funktionsprinzip, wie es auch aus der vorgenannten DE 102011006021 A1 bekannt ist, erkannt werden.

In der Fig. 4 ist für das Aufnahmegehäuse 11 in vier Darstellungen das Durchlaufen einer Zahl bzw. eine Änderung der Zahl "3" in die Zahl "4" dargestellt. Mittels der oben links beispielhaft gestrichelt eingezeichneten LED 26 können die Lichtleitkanäle 14 beleuchtet werden, was durch die Schraffierung dargestellt ist. Dies kann durch ein wischendes Darüberziehen eines aufgelegten Fingers entsprechend der vorgenannten DE 102011006021 A1 erfolgen. Die einzelnen Segmente, die mit ihrer Leuchtwirkung zusammen die Zahl ergeben, werden dann entsprechend angesteuert, so dass sich die optische Lauf-Erscheinung ergibt. Sie kann vertikal sein, wie hier dargestellt ist. Alternativ kann die Bedieneinrichtung horizontal ausgerichtet sein, die Reihen 15a bis 15c also horizontal verlaufen. Dann kann eine Art Laufschrift erzeugt werden samt horizontaler Wischbewegung. Hier ist auch zu erkennen, dass die weniger feine Aufteilung der Lichtleitkanäle 14 der mittleren Reihe 15b eine Art sprungartige Bewegung der Zahlen ergibt. Dies könnte auch anders sein, wenn nämlich in der mittleren Reihe 15b ebenso viele Lichtleitkanäle 14 vorhanden wären wie in den anderen beiden Reihen 15a und 15c.

In der Fig. 5 ist für eine alternative Bedieneinrichtung ein etwas anders ausgebildetes Aufnahmegehäuse 111 dargestellt. Hier sind zwar wieder drei Reihen 115a bis 115c von Lichtleitkanälen 114 und somit Anzeigeelementen vorgesehen, aber insgesamt deutlich weniger. Die mittlere Reihe 115b weist nur drei Lichtleitkanäle 114 auf, während die Reihen 115a links und 115c rechts daneben jeweils fünf aufweisen. Die Sensorelemente 117a bis 117c werden nur von vier im Rechteck verlaufenen Rippen 119a bis 119c gebildet, was aber für eine Bedienung ausreicht. Mittels der beispielhaft gestrichelt eingezeichneten LED 126 können wiederum die Lichtleitkanäle 114 beleuchtet werden, was durch die Schraffierung dargestellt ist. Hier können die durchlaufenden Zahlen nur in einem kleineren Ausschnitt dargestellt werden, was aber auch ausreichen kann.

## Patentansprüche

1. Bedieneinrichtung für ein Elektrogerät mit mehreren Anzeigeelementen, mehreren kapazitiven Sensorelementen (17a-17c) als Bedienelemente und einer lichtdurchlässigen Bedienfläche,
unter der die Anzeigeelemente und die Sensorelemente angeordnet sind für eine Bedienung durch Auflegen eines Fingers und/oder Darüberziehen eines aufgelegten Fingers, wobei die Bedieneinrichtung ein Aufnahmegehäuse (11) mit einer Oberseite aufweist, wobei das Aufnahmegehäuse Lichtleitkanäle (14) aufweist und wobei in den Lichtleitkanälen Leuchtmittel (26) als Anzeigeelemente angeordnet sind, wobei die Sensorelemente an der Oberseite zur Bedienfläche hin angeordnet sind und an der Oberseite zwischen den Lichtleitkanälen verlaufen,
wobei die Sensorelemente aus elektrisch leitfähigem Kunststoff bestehen und in mindestens zwei voneinander getrennte Bereiche auf dem Aufnahmegehäuse aufgeteilt sind, wobei innerhalb dieser Bereiche jedes Sensorelement zusammenhängend aus durchgehendem elektrisch leitfähigem Kunststoff ausgebildet ist, **dadurch gekennzeichnet, dass**
die Sensorelemente in einer Längsrichtung des Aufnahmegehäuses in verschiedene zusammenhängende Bereiche aufgeteilt sind und pro zusammenhängendem Bereich mindestens zweimal quer über die Oberseite des Aufnahmegehäuses verlaufen.

2. Bedieneinrichtung nach Anspruch 1, **dadurch gekennzeichnet, dass** von jedem zusammenhängenden Sensorelement bzw. dem zusammenhängenden elektrisch leitfähigen Kunststoff eine elektrische Kontaktierung an einen unteren Bereich bzw. eine Unterseite des Aufnahmegehäuses geführt ist.

3. Bedieneinrichtung nach Anspruch 2, **dadurch gekennzeichnet, dass** die elektrische Kontaktierung an den unteren Bereich bzw. die Unterseite des Aufnahmegehäuses durch einen nach unten verlaufenden Verbindungsabschnitt aus dem elektrisch leitfähigen Kunststoff gebildet ist, vorzugsweise mit einem Kontaktierungsvorsprung am unteren Ende bzw. an der Unterseite des Aufnahmegehäuses.

4. Bedieneinrichtung nach einem der vorhergehenden Ansprüche, **dadurch gekennzeichnet, dass** das Aufnahmegehäuse mit den Lichtleitkanälen und den Sensorelementen eine einzige Baueinheit bildet, insbesondere einteilig und einstückig hergestellt ist.

5. Bedieneinrichtung nach einem der vorhergehenden Ansprüche, **dadurch gekennzeichnet, dass** in den Lichtleitkanälen transparentes oder transluzentes Lichtleitermaterial angeordnet ist.

6. Bedieneinrichtung nach Anspruch 5, **dadurch gekennzeichnet, dass** die Lichtleitkanäle mit Lichtleitermaterial zusammen mit dem Aufnahmegehäuse einteilig und einstückig hergestellt sind in einem Mehrkomponenten-Kunststoffspritzgussverfahren.

7. Bedieneinrichtung nach einem der vorhergehenden Ansprüche, **dadurch gekennzeichnet, dass** die Sensorelemente zusammen mit dem Aufnahmegehäuse einteilig und einstückig hergestellt sind in einem Mehrkomponenten-Kunststoffspritzgussverfahren.

8. Bedieneinrichtung nach Anspruch 7, **dadurch gekennzeichnet, dass** die Sensorelemente zusammen mit dem Aufnahmegehäuse einteilig und einstückig hergestellt sind zusammen mit den Lichtleitkanälen bzw. mit dem Lichtleitermaterial in einem Mehrkomponenten-Kunststoffspritzgussverfahren.

9. Bedieneinrichtung nach einem der vorhergehenden Ansprüche, **dadurch gekennzeichnet, dass** die Lichtleitkanäle in einer Längsrichtung des Aufnahmegehäuses gesehen in drei Reihen nebeneinander angeordnet sind.

10. Bedieneinrichtung nach Anspruch 9, **dadurch gekennzeichnet, dass** innerhalb einer Reihe alle Lichtleitkanäle gleich groß ausgebildet sind.

11. Bedieneinrichtung nach Anspruch 9 oder 10, **dadurch gekennzeichnet, dass** die Lichtleitkanäle der linken Reihe und der rechten Reihe gleich groß sind.

12. Bedieneinrichtung nach Anspruch 11, **dadurch gekennzeichnet, dass** die Lichtleitkanäle der mittleren Reihe größer ausgebildet sind als die Lichtleitkanäle der linken Reihe und der rechten Reihe.

13. Bedieneinrichtung nach einem der Ansprüche 9 bis 12, **dadurch gekennzeichnet, dass** entlang der linken Reihe und der rechten Reihe in jedem Lichtleitkanal ein Leuchtmittel angeordnet ist und die Lichtleitkanäle einer Reihe nur unterbrochen durch eine dünne Wand des Aufnahmegehäuses und ein Sensorelement darauf benachbart zueinander angeordnet sind, wobei vorzugsweise in der mittleren Reihe von Lichtleitkanälen ein mittlerer Lichtleitkanal nur entsprechend jedem zweiten Lichtleitkanal der linken Reihe und der rechten Reihe vorgesehen ist.

14. Bedieneinrichtung nach einem der vorhergehenden Ansprüche, **dadurch gekennzeichnet, dass** die Sensorelemente in der Draufsicht auf das Aufnahmegehäuse netzartig verteilt ausgebildet sind.

15. Elektrogerät mit einer Bedieneinrichtung nach einem der vorhergehenden Ansprüche, wobei die Bedienfläche bzw. Blende Teil des Elektrogeräts ist.

## Claims

1. Operating device for an electrical appliance having several display elements, several capacitive sensor elements (17a-17c) as operating elements and a translucent operating surface, with the display elements and the sensor elements disposed underneath the operating surface for operation by applying a finger and/or drawing of a finger applied thereon, wherein the operating device has a supporting housing (11) with an upper side, wherein the supporting housing includes light conductor channels (14), and wherein in the light conductor channels are disposed illuminating means (26) as display elements, wherein the sensor elements are disposed on the upper side towards the operating surface and extend on the upper side between the light conductor channels, wherein the sensor elements are made of electrically conducting synthetic material and are divided in at least two separate regions on the supporting housing, wherein within said regions each sensor element is configured coherently from continuous electrically conducting synthetic material,
**characterized in that**
the sensor elements are divided in different coherent regions in a longitudinal direction of the supporting housing and, per coherent region, extend at least twice transversely over the upper side of the supporting housing.

2. Operating device according to claim 1, **characterized in that** from each coherent sensor element or the coherent electrically conducting synthetic material, an electrical contacting is provided to a lower region or a bottom side of the supporting housing.

3. Operating device according to claim 2, **characterized in that** the electrical contacting to the lower region or the bottom side of the supporting housing is composed of a downwards extending connecting section made of the electrically conducting synthetic material, preferably having a contacting protrusion on the lower end or on the bottom side of the supporting housing.

4. Operating device according to any of the preceding claims, **characterized in that** the supporting housing together with the light conductor channels and the sensor elements is a single constructional unit, in particular produced integrally and in one piece.

5. Operating device according to any of the preceding claims, **characterized in that** transparent or translucent light conductor material is disposed within the light conductor channels.

6. Operating device according to claim 5, **characterized in that** the light conductor channels having light conductor material together with the supporting housing are produced integrally and in one piece using a multi-component synthetic material injection moulding method.

7. Operating device according to any of the preceding claims, **characterized in that** the sensor elements together with the supporting housing are produced integrally and in one piece using a multi-component synthetic material injection moulding method.

8. Operating device according to claim 7, **characterized in that** the sensor elements together with the supporting housing are produced integrally and in one piece together with the light conductor channels and the light conductor material, respectively, using a multi-component synthetic material injection moulding method.

9. Operating device according to any of the preceding claims, **characterized in that** the light conductor channels are arranged in three juxtaposed rows, as seen in a longitudinal direction of the supporting housing.

10. Operating device according to claim 9, **characterized in that** within one row all the light conductor channels are equal in size.

11. Operating device according to claim 9 or 10, **characterized in that** the light conductor channels of the left row and of the right row are equal in size.

12. Operating device according to claim 11, **characterized in that** the light conductor channels of the central row are greater than the light conductor channels of the left row and of the right row.

13. Operating device according to any of claims 9 to 12, **characterized in that** along the left row and the right row, an illuminating means is disposed in each light conductor channel and the light conductor channels of one row are in a mutually adjacent arrangement, discontinued only by a thin wall of the supporting housing and a sensor element thereon, wherein preferably in the central row of light conductor channels one central light conductor channel is provided correspondingly only in every second light conductor channel of the left row and the right row.

14. Operating device according to any of the preceding claims, **characterized in that** the sensor elements are in a web-type distribution on the supporting housing, as seen in a top view.

15. Electrical appliance having an operating device according to any of the preceding claims, wherein the operating surface and cover plate, respectively, is part of the electrical appliance.

## Revendications

1. Dispositif de commande pour un appareil électrique, présentant plusieurs éléments d'affichage, plusieurs éléments capacitifs de détection (17a-17c) servant d'éléments de commande et une surface de commande transparente en dessous de laquelle les éléments d'affichage et les éléments de détection sont disposés pour permettre une commande par pose d'un doigt et/ou balayage du doigt qui a été posé,
le dispositif de commande présentant un boîtier de réception (11) doté d'un côté supérieur,
le boîtier de réception présentant des canaux (14) de guidage de lumière et des moyens d'éclairage (26) étant disposés comme éléments d'affichage dans les canaux de guidage de lumière,
les éléments de détection étant disposés sur le côté supérieur en direction de la surface de commande et s'étendent sur le côté supérieur entre les canaux de guidage de lumière,
les éléments de détection étant constitués de matière synthétique électriquement conductrice et étant réparties sur le boîtier de réception dans au moins deux parties mutuellement séparées, chaque élément de détection étant continu à l'intérieur de ces parties réalisées en matière synthétique électriquement conductrice à coeur,
**caractérisé en ce que**
les éléments de détection sont répartis dans différentes parties continues dans le sens de la longueur du boîtier de réception et pour chaque partie continue, ils s'étendent au moins deux fois transversalement au-dessus du côté supérieur du boîtier de réception.

2. Dispositif de commande selon la revendication 1, **caractérisé en ce qu'**un contact électrique est guidé sur une partie inférieure ou un côté inférieur du boîtier de réception par chaque élément de détection continu ou par la matière synthétique électriquement conductrice continue.

3. Dispositif de commande selon la revendication 2, **caractérisé en ce que** le contact électrique sur la partie inférieure ou le côté inférieur du boîtier de réception est formé par une section de liaison qui s'étend vers le bas, en matière synthétique électriquement conductrice, de préférence avec une saillie de mise en contact sur l'extrémité inférieure ou sur le côté inférieur du boîtier de réception.

4. Dispositif de commande selon l'une des revendications précédentes, **caractérisé en ce que** le boîtier de réception forme avec les canaux de guidage de lumière et les éléments de détection un composant unique qui est réalisé en particulier en monobloc et d'un seul tenant.

5. Dispositif de commande selon l'une des revendications précédentes, **caractérisé en ce qu'**un matériau de guidage de lumière transparent ou translucide est placé dans les canaux de guidage de lumière.

6. Dispositif de commande selon la revendication 5, **caractérisé en ce que** les canaux de guidage de lumière et le matériau de guidage de lumière sont fabriqués en monobloc et d'un seul tenant avec le boîtier de réception, dans un procédé de moulage par injection de matière synthétique à plusieurs composants.

7. Dispositif de commande selon l'une des revendications précédentes, **caractérisé en ce que** les éléments de détection sont fabriqués en monobloc et d'un seul tenant avec le boîtier de réception, dans un procédé de moulage par injection de matière synthétique à plusieurs composants.

8. Dispositif de commande selon la revendication 7, **caractérisé en ce que** les éléments de détection sont fabriqués en monobloc et d'un seul tenant avec le boîtier de réception et avec les canaux de guidage de lumière et le matériau de guidage de lumière dans un procédé de moulage par injection de matière synthétique à plusieurs composants.

9. Dispositif de commande selon l'une des revendications précédentes, **caractérisé en ce que** les canaux de guidage de lumière sont disposés les uns à côté des autres en trois rangées dans le sens de la longueur du boîtier de réception.

10. Dispositif de commande selon la revendication 9, **caractérisé en ce que** dans une rangée, tous les canaux de guidage de lumière ont la même taille.

11. Dispositif de commande selon les revendications 9 ou 10, **caractérisé en ce que** les canaux de guidage de lumière de la rangée de gauche et de la rangée de droite ont la même taille.

12. Dispositif de commande selon la revendication 11, **caractérisé en ce que** les canaux de guidage de lumière de la rangée centrale sont plus grands que les canaux de guidage de lumière de la rangée de gauche et de la rangée de droite.

13. Dispositif de commande selon l'une des revendications 9 à 12, **caractérisé en ce qu'**un moyen d'éclairage est disposé dans chaque canal de guidage de lumière le long de la rangée de gauche et de la rangée de droite, les canaux de guidage de lumière d'une rangée étant interrompus uniquement par une mince paroi du boîtier de réception et un élément de détection voisin y est placé, un canal central de guidage de lumière étant prévu uniquement en correspondance à un canal de guidage de lumière sur deux de la rangée de gauche et de la rangée de droite, de préférence dans la rangée centrale de canaux de guidage de lumière.

14. Dispositif de commande selon l'une des revendications précédentes, **caractérisé en ce que** les éléments de détection présentent dans une vue en plan du boîtier de réception une répartition en réseau.

15. Appareil électrique doté d'un dispositif de commande selon l'une des revendications précédentes, la surface de commande ou écran faisant partie de l'appareil électrique.
